# EUROPEAN PATENT APPLICATION

(11) **EP 4 068 350 A1**
(43) Date of publication of application: **05.10.2022**
(21) Application number: 21306771.3
(22) Date of filing: 14.12.2021
(51) Int. Cl.: H01L 23/367, H01L 23/44, H01L 23/473

(54) **HEAT SINK HAVING NON-STRAIGHT FINS FOR ORIENTING A FLOW OF AN IMMERSIVE COOLING FLUID**

(30) Priority: 01.04.2021 EP 21305427
(71) Applicant: OVH, 59100 Roubaix (FR)
(72) Inventor: CHEHADE, Ali, 59283 Moncheaux (FR); HNAYNO, Mohamad, 59100 Roubaix (FR); BAUDUIN, Hadrien, 59650 Villeneuve d'Ascq (FR)
(74) Representative: BCF Global

(57) **Abstract**

A heat sink for collecting thermal energy from a heat generating component. The heat sink comprises a base comprising a thermal transfer surface configured to be placed in thermal contact with the heat-generating component, an external surface opposite from the thermal transfer surface and an inlet side of the base extending between an edge of the thermal transfer surface and an edge of the external surface and a plurality of fins extending from the external surface. The fins define a plurality of fin passages therebetween, at least one fin of the plurality of fins having non-straight longitudinal edges extending along the external surface and defining at least in part at least one non-straight fin passage.

## Description

### CROSS-REFERENCE

The present patent application claims priority from European Patent Application Number 21305427.3, filed on April 1, 2021, the disclosure of which is incorporated by reference herein in its entirety.

### FIELD OF TECHNOLOGY

The present technology relates to heat sinks, and more particularly to heat sinks with non-straight fins that orient a flow of an immersive cooling fluid in non-straight directions.

### BACKGROUND

Many components of a computer system, such as processors (also referred to as central processing units (CPU)), generate heat and thus require cooling to avoid performance degradation and, in some cases, failure. Moreover, with advancing technological progress, computer components are not only becoming more performant but also have a greater associated thermal design power (TDP) (i.e., a maximum amount of thermal energy generated thereby, which a cooling system should dissipate) thus emphasizing the need to improve cooling solutions therefor. Heat sinks are used to locally collect thermal energy from those heat-generating components. Notably, a heat sink is thermally coupled to the heat-generating component to be cooled (e.g., the processor) and a cooling fluid (e.g. ambient air) flows between fins of the heat sink to collect thermal energy from the heat sink. The heated ambient air may be directed to be further cooled down and/or renewed with cold air to remove thermal energy from a vicinity of the heat generating component.

However, combining a plurality of conventional heat sinks may not be suitable for providing efficient global cooling to computer systems comprising a plurality of said heat sinks. Indeed, geometry of the fins of the heat sinks typically limit a flow of the cooling fluid in a vicinity of the computer system such that a cooling capacity of the cooling fluid may be at least partly wasted.

There is therefore a desire for a heat sink which can alleviate at least some of these drawbacks.

### SUMMARY

It is an object of the present technology to ameliorate at least some of the inconveniences present in the prior art.

According to one aspect of the present technology, there is provided a heat sink for collecting thermal energy from a heat generating component, the heat sink comprising a base comprising a thermal transfer surface configured to be placed in thermal contact with the heat-generating component, an external surface opposite from the thermal transfer surface, and an inlet side of the base extending between an edge of the thermal transfer surface and an edge of the external surface and a plurality of fins extending from the external surface, the fins defining a plurality of fin passages therebetween, at least one fin of the plurality of fins having non-straight longitudinal edges extending along the external surface and defining at least in part at least one non-straight fin passage.

In some embodiments, fin sections of two adjacent fins divergently extend from one another along the external surface.

In some embodiments, fin sections of two adjacent fins convergently extend towards one another along the external surface.

In some embodiments, at least two adjacent fins define a curved fin passage therebetween along the external surface.

In some embodiments, the heat sink is configured to be in thermal contact with an external fluid to transfer thermal energy from the heat generating component to the external fluid.

In some embodiments, the external fluid is an immersive cooling liquid, the heat sink being at least partially immersed in the immersive cooling liquid.

In some embodiments, the plurality of fins is configured to allow the immersive cooling liquid to flow between the fins, the flow of the immersive cooling liquid being directed by longitudinal edges of the plurality of fins.

In some embodiments, the plurality of fins is configured to direct the flow of the immersive cooling liquid in a plurality of directions.

In some embodiments, the heat sink is made of a material selected from copper, aluminum, an aluminum alloy and a combination thereof.

In some embodiments, the heat sink is formed by injection molding.

In some embodiments, the at least one fin defines a plurality of fin sections along the external surface, each fin section extending at an angle with respect to a successive fin section.

In some embodiments, an immersion cooling tank for cooling a heat-generating component, the immersion cooling tank comprising a heat sink placed in thermal contact with the heat-generating component, the immersion cooling tank being configured to circulate immersive cooling liquid such that the immersive cooling liquid flows between the fins, thereby transferring thermal energy from the heat sink to the immersive cooling liquid.

According to another aspect of the present technology, there is provided a method for cooling a heat-generating component, the method comprising providing an immersion cooling tank, installing the heat sink as defined in the above paragraphs on the heat-generating component, placing the heat-generating component in the immersion cooling tank and filling the immersion cooling tank with an immersive cooling liquid such that the immersive cooling liquid flows between the fins, thereby transferring thermal energy from the heat sink to the immersive cooling liquid.

In some embodiments, the immersive cooling liquid is a dielectric liquid.

In some embodiments, the heat-generating component is placed in the immersion cooling tank such that the plurality of fins of the heat sink extend generally horizontally.

In some embodiments, the method further comprising disposing a tank liquid inlet in a vicinity of the inlet side of the heat sink and orienting a flow of the immersive cooling liquid towards the inlet side.

Embodiments of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of embodiments of the present technology will become apparent from the following description, the accompanying drawings and the appended claims.

It is to be understood that terms relating to the position and/or orientation of components such as "upper", "lower", "top", "bottom", "front", "rear", "left", "right", are used herein to simplify the description and are not intended to be limitative of the particular position/orientation of the components in use.

### BRIEF DESCRIPTION OF THE DRAWINGS

For a better understanding of the present technology, as well as other aspects and further features thereof, reference is made to the following description which is to be used in conjunction with the accompanying drawings, where:
Figure 1 (prior art) is a front elevation view of a conventional heat sink;
Figure 2 (prior art) is a top view of the conventional heat sink of Figure 1;
Figure 3 is a front elevation view of a heat sink in accordance with an embodiment of the present technology;
Figure 4 is a top view of the heat sink of Figure 3;
Figure 5 is a perspective view of the heat sink of Figure 3;
Figure 6 is a top view of another heat sink in accordance with an embodiment of the present technology;
Figure 7 is a top view of yet another heat sink in accordance with another embodiment of the present technology;
Figure 8 is a schematic diagram of a cooling system comprising the heat sink of Figure 7; and
Figure 9 is a schematic diagram of another cooling system comprising the heat sink of Figure 7.

### DETAILED DESCRIPTION

Various representative embodiments of the disclosed technology will be described more fully hereinafter with reference to the accompanying drawings, in which representative embodiments are shown. The presently disclosed technology may, however, be embodied in many different forms and should not be construed as limited to the representative embodiments set forth herein. Rather, these representative embodiments are provided so that the disclosure will be thorough and complete, and will fully convey the scope of the present technology to those skilled in the art. In the drawings, the sizes and relative sizes of layers and regions may be exaggerated for clarity. Like numerals refer to like elements throughout. And, unless otherwise defined, all technical and scientific terms used herein have the same meaning as commonly understood by one of ordinary skill in the art to which the described embodiments pertain.

Generally speaking, a heat sink is a passive heat exchanger that may be disposed on a heat generating component (e.g. Computing Processing Units (CPUs), Graphics Processing Units (GPUs), chipsets or Random-Access Memory (RAM) modules) to be cooled. The heat sink defines a plurality of fins and transfers the thermal energy generated by the heat generating component to a cooling fluid (e.g. ambient air or fluid medium) flowing between said fins. Thermal energy is thus carried away from the device, thereby allowing regulation of the temperature of the heat generating component.

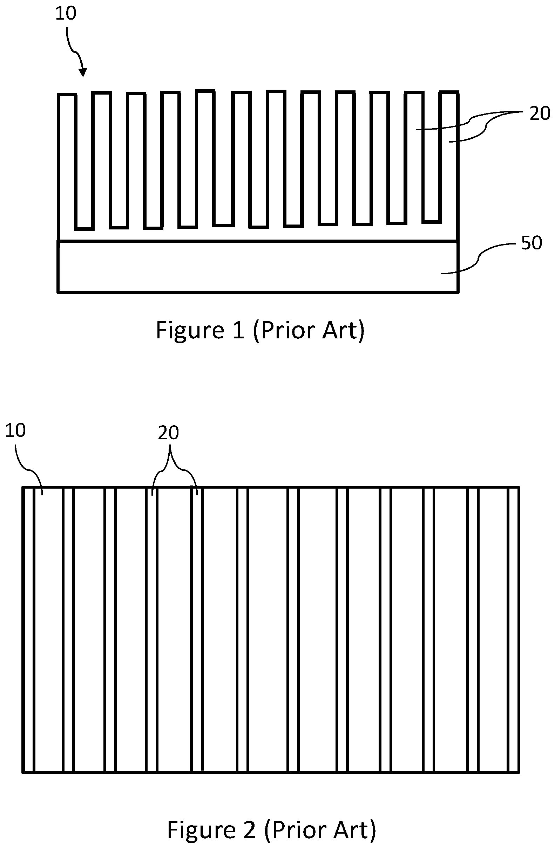

Referring now to the drawings, Figures 1 and 2 respectively illustrate a front elevation view and a top view of a conventional heat sink 10 disposed on a heat generating component 50, the heat sink 10 being configured for dissipating thermal energy of the heat-generating component 50. In this example, the heat-generating component 50 is a central processing unit (CPU) of a computer system and is mounted to a motherboard thereof (not shown). In use, the CPU 50 generates a significant amount of thermal energy and can benefit from cooling. It is contemplated that the heat-generating component 50 could be any other suitable heat-generating electronic component (e.g., a graphics processing unit (GPU)) or an intermediary component disposed between the heat sink 10 and a heat-generating component.

In use, the heat sink 10 is typically disposed atop the heat-generating component 50 and is in thermal contact with the heat-generating component 50 such as to allow the heat sink 10 to absorb thermal energy therefrom. The fins 20 are straight and extend in a depth direction of the heat sink 10. The cooling fluid typically flows between the fins 20 and collects thermal energy of the heat sink 10. Thermal energy is thus carried away from the heat generating component 50.

Given the geometry of the fins 20, the flow of the cooling fluid is limited to having a straight direction, which may cause undesirable turbulences in the flow of the cooling fluid. As an example, two heat sinks 10 disposed in a vicinity from each other may mutually obstruct the flow of the cooling fluid when the fins 20 of both heat sinks 10 are not extending along a same direction. As an example, the depth directions of the two heat sinks may be orthogonal due to mechanical constraints. In this situation, the cooling fluid flowing between the fins 20 of one heat sink 10 is at least partially blocked by the other heat sink 10.

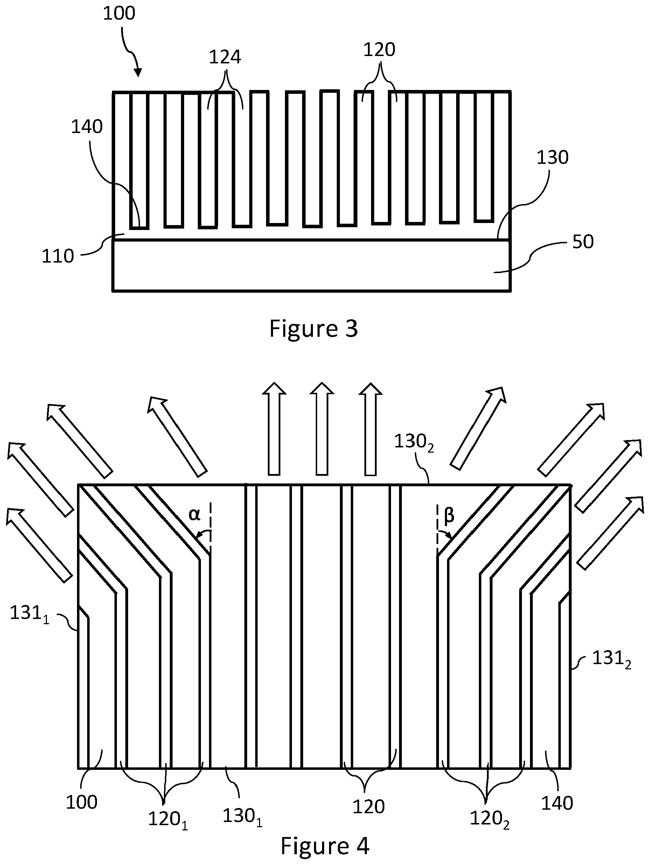

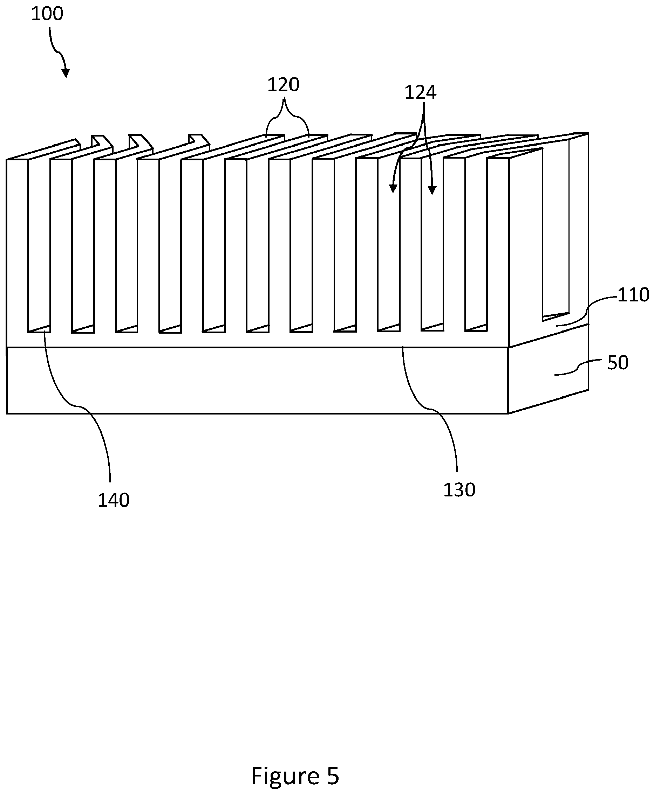

With reference to Figures 3 to 5, a heat sink 100 is illustrated in accordance with one embodiment of the present technology. The heat sink 100 comprises a base 110 and a plurality of fins 120 extending from the base 110. A geometry of the fins 120 is described in greater details hereinafter. In this embodiment, the base 110 comprises a thermal transfer surface 130 on a first side of the heat sink 100 configured to be in thermal contact with the heat-generating component 50. It is to be understood that in this context, the thermal transfer surface 130 is said to be "in thermal contact" with the heat-generating component 50 either when the thermal transfer surface 130 is in direct contact with the heat-generating component 50 or when a thermal paste or any thermal interface material (TIM) is applied between the thermal transfer surface 130 and the heat-generating component 50, as long as adequate heat transfer is provided between the heat-generating component 50 and the thermal transfer surface 130.

The base 110 also comprises an external surface 140 on an opposite side of the base 110 from the thermal transfer surface 130. The external surface 140 is generally parallel to the thermal transfer surface 130 and faces in a direction opposite thereof. The fins 120 extend from the external surface 140, for example perpendicularly therefrom. With reference to Figure 4, in this embodiment, the base 110 has front and rear longitudinal ends 130₁, 130₂, and opposite lateral ends 131₁, 131₂. In the context of the present disclosure, a depth direction of the heat sink 100 is defined between the front and rear longitudinal ends 130₁, 130₂. Besides, the cooling fluid is expected to enter fin passages 124 from the front longitudinal ends 130₁ (e.g. a fluid inlet delivering the cooling fluid may be disposed in a vicinity of the heat sink 100 and towards the front longitudinal ends 130₁). As shown, the fin passages 124 are external in that they are defined between fins 120 that extend away from the base 110. As such, the front longitudinal ends 130₁ may be referred to as an "inlet side" 130₁ of the fin passages 124 for receiving, in use, the cooling fluid.

In this embodiment, the base 110 and the fins 120 are made of a thermally conductive material such as metal, for instance copper, aluminum or aluminum alloys. However, it is contemplated that the base 110 and the fins 120 could be made from different thermally conductive materials in other embodiments, including combining different materials (e.g., the base 110 made from a different material than the fins 120). In a non-limiting embodiment, the fins 120 are laserwelded to the base 110. In another non-limiting embodiment, the fin passages 124 are machined into the external surface 140 to form the fins 120. For example, the fin passages 124 may be milled into the external surface 140 by a milling machine (e.g., a numerically controlled mill). The fin passages 124 may be provided in any other suitable way in other embodiments (e.g., molded or machined using electro erosion). Other configurations of the heat sink 100 are contemplated. For instance, the heat sink 100 may be formed of a mono-block body that may be made via 3D printing.

In this embodiment, as best shown on Figure 4, some of the fins 120 are non-straight fins. More specifically, in this illustrative embodiment, each fin of a first set of fins 120₁ comprises a first fin section extending from the inlet side 130₁ in the depth direction, and a second fin section extending from the first fin section of the respective fin 120₁ at an angle (α). In the illustrative embodiment, of Figure 3, each second fin section of the fins 120₁ extend in a same direction. Alternative embodiments wherein the second fin sections of the fins 120₁ extend in different directions forming, for example, different angles αᵢ are also contemplated. The second fin sections of the first set of fins 120₁ extend at an angle 0<α<180° relative to the depth direction. As such, the second fin sections of the fins 120₁ extends divergently with respect to the straight fins 120 of the heat sink 100.

Similarly, in this illustrative embodiment, each fin of a second of set of fins 120₂ comprises a first fin section extending from the inlet side 130₁ in the depth direction, and a second fin section extending from the first fin section of the respective fin 120₂ at an angle (β). In the illustrative embodiment, of Figure 3, each second fin section of the fins 120₂ extend in a same direction. Alternative embodiments wherein the second fin sections of the fins 120₂ extend in different directions forming, for example, different angles βᵢ are also contemplated. The second fin sections of the second set of fins 120₂ extend at an angle β = -α < 0 relative to the depth direction. The absolute value of β may be different from α in alternative embodiments (0< | β | <180°).

In the illustrative embodiment of Figures 3 to 5, the first set of fins 120₁ may thus orient the cooling fluid flowing within the fin passages 124 from the inlet side 130₁ to an area in a vicinity of a corner of the heat sink defined by intersection of the rear ends 130₂ and lateral end 131₁. As such, the first set of fins 120₁ may thus orient the cooling fluid to collect thermal energy from another heat generating component located near said corner. Similarly, the second set of fins 120₂ may thus orient the cooling fluid flowing within the fin passages 124 from the inlet side 130₁ to an area in a vicinity of a corner of the heat sink defined by intersection of the rear ends 130₂ and lateral end 131₂. As such, the second of set of fins 120₂ may thus orient the cooling fluid to collect thermal energy from another heat generating component located near said corner. In this embodiment, as shown in Figure 4, the length of each fin 120 corresponds to at least a majority of the length of the heat sink 100, the length of the heat sink 100 being defined along the depth direction. In another embodiment, one or more fins 120 may comprise a plurality of straight fin sections, each fin section extending at an angle relative to a successive straight fin section.

Summarily, the first and second sets of fins 120₁, 120₂ define non-straight fin passages 124 that may conduct or at least orient a flow of the cooling fluid towards other heat generating component located in a vicinity of the heat generating component 50. Therefore, the heat sink 100 with non-straight fins may collect thermal energy from the heat generating component 50 while guiding the cooling fluid in a vicinity of the heat generating component 50 in specific directions. A flow generator (e.g. a fan, a pump) of the cooling fluid may thus consume less energy to direct the cooling fluid towards the heat generating components to be cooled.

As best shown in Figure 4, the angles between two straight fin sections of the first and second sets of fins 120₁, 120₂ are sharp, but filleted angles are also contemplated.

It is contemplated that a fluid (e.g., a refrigerant, a dielectric fluid or any fluid suitable for heat transfer purposes) other than air could be used to collect thermal energy from the heat sink 100 in some embodiments. For example, in some instance, the fluid may be an oil, an alcohol, or a dielectric fluid (e.g., 3M Novec ^{®}).

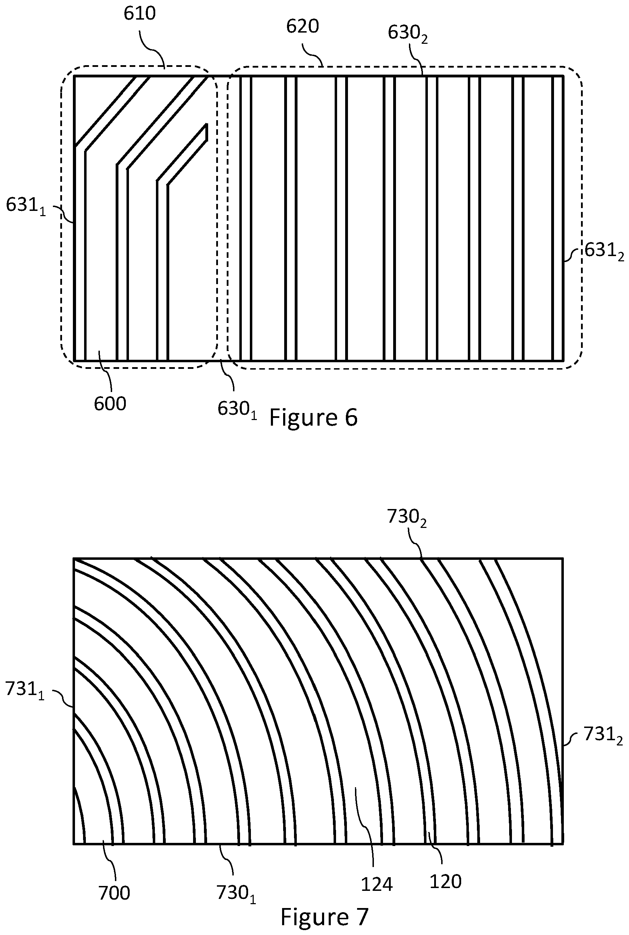

With respect to Figures 6 and 7, alternative embodiments of the heat sink 100 are illustrated. More specifically, Figure 6 illustrates the heat sink 600 having a set 610 of non-straight fins and a set 620 of straight fins. Each fin of the set 610 comprises a first fin section that is straight with respect of the heat sink 600 (i.e. extending along the depth direction) and a second fin section extending from the first fin section at an angle. In this illustrative embodiment, the second fin section extends inwardly with respect to the heat sink 600. In other words, it can be said that the second fin section converge towards the set 620 of straight fins. More specifically, in the illustrative embodiment of Figure 6, the second fin section of a rightmost non-straight fin convergently extend towards a leftmost one of the straight fins along the external surface 140.

As an example, the heat sink 600 of Figure 6 may be used to prevent the cooling fluid entering at an inlet side 630₁ from being directed towards a vicinity of the corner defined by intersection of a rear ends 630₂ and a lateral end 631₁.

In the illustrative embodiment of Figure 7, the fins 120 extend along an ellipsoidal pattern such that the external fluid entering the fin passages 124 at the inlet side 130₁ is guided, in this example, towards the corner of the heat sink 700 defined by intersection of a rear end 730₂ and a lateral end 731₁. More specifically, in the illustrative embodiment of Figure 7, the cooling fluid exits the fin passages 124 either at the rear end 730₂ or at the lateral end 731₁ with an orientation of the flow defining an angle with respect to the depth direction.

Referring back to Figure 3 to 7, it should be understood that each one of the non-straight fins of the heat sinks 100, 600 and 700 may have a different geometry. Notably, a heat sink according to one non-limiting embodiment may comprise, for example, a first set of fins having a geometry similar to the fins 120₁ of the heat sink 100, a second set of fins having a geometry similar to the fins 120₂ of the heat sink 100, a third set of fins having a geometry similar to the fins 120 of the set 610 of the heat sink 600, a fourth set of fins having a geometry similar to the fins 120 of the heat sink 700 and/or a fifth set of straight fins. More generally, a heat sink according to one non-limiting embodiment may comprise any combination of fins having different geometries described herein without departing from the scope of the present technology.

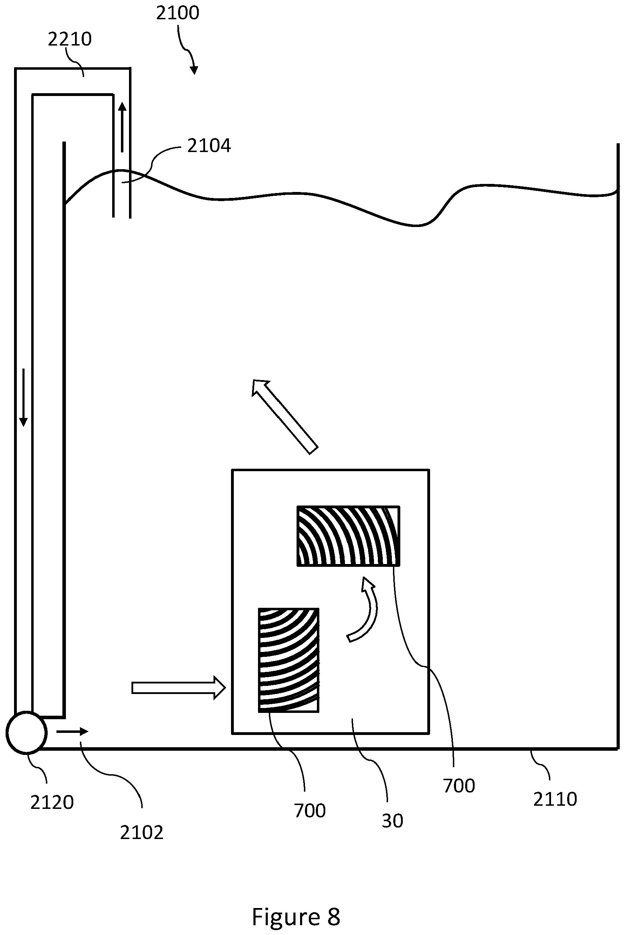

Figure 8 is a schematic diagram of a cooling system 2000 comprising an immersion cooling arrangement 2100. In this embodiment, the immersion cooling arrangement 2100 comprises a tank 2110 filled with a dielectric heat transfer fluid collecting thermal energy of the heat generating components 50 (shown on earlier Figures), the heat generating components 50 being disposed under respective heat sinks 700 and on a support board 30 (e.g. a Printed Circuit Board). As such, the heat generating components 50 and the heat sinks 700 are at least partially immersed in the dielectric heat transfer fluid. On Figure 8, the shown heat sinks 700 are as described in the foregoing description of Figure 7. It should be understood that heat sinks 100 or 600 as described in Figures 3-6 could alternatively be mounted on the heat generating components 50. A pump 2120 fluidly connected to the tank 2110 maintains a flow of the dielectric heat transfer fluid within the tank 2110. The pump 2120 may be external with respect to the tank 2110 or immersed within the tank 2110. A cooling apparatus (not shown) may be provided along an external fluid conduit 2210 to cool the dielectric heat transfer fluid. On the illustrative example of Figure 8, the pump 2120 causes a flow of the dielectric heat transfer fluid from a surface of the tank 2110 to a bottom thereof such that the tank 2110 receives cooled dielectric heat transfer fluid at a tank inlet 2102. In alternative embodiments, the pump 2120 may be omitted, the flow of the dielectric heat transfer fluid being caused by natural convection. In such embodiments, the tank inlet 2102, the tank outlet 2104, and the external fluid conduit 2210 may also be omitted, and the dielectric heat transfer fluid may be cooled by other means (e.g. immersed coils connected to an external cooling loop of a second heat transfer fluid).

As illustrated by the white arrows on Figure 8, a flow of the dielectric heat transfer fluid is at least in part directed by the two heat sinks 700 of the support board 30. More specifically, the dielectric heat transfer fluid entering the tank 2110 at the tank inlet 2102 is directed towards the support board 30 comprising the heat-generating components 50 to be cooled. The dielectric heat transfer fluid flows in the fin passages 124 of the fins 120 of a first heat sink 700, the first heat sink 700 being disposed to substantially extend along a vertical axis on Figure 8. In the particular example of Figure 8, in which the fins 120 of the heat sinks 700 are non-straight, the heat transfer fluid flow is directed from a substantially horizontal direction to a substantially vertical direction. Mounting the heat sinks of Figures 4 or 6 in various orientations on the heat-generating components 50 could provide to direct the heat transfer fluid flow in the same or other directions. In the example as illustrated on Figure 8, the warm dielectric heat transfer fluid may then flow in the fin passages 124 of the fins 120 of a second heat sink 700, the second heat sink 700 being disposed such that the inlet side 130₁ thereof may receive the dielectric heat transfer fluid exiting the fin passages 124 of the first heat sink 700, the second heat sink 700 being disposed to substantially extend along a horizontal axis on Figure 8. In this example, the heated dielectric heat transfer fluid that collected thermal energy from the first and second heat sinks 700 is thus directed towards a tank outlet 2104 by the fins of the second heat sink 700.

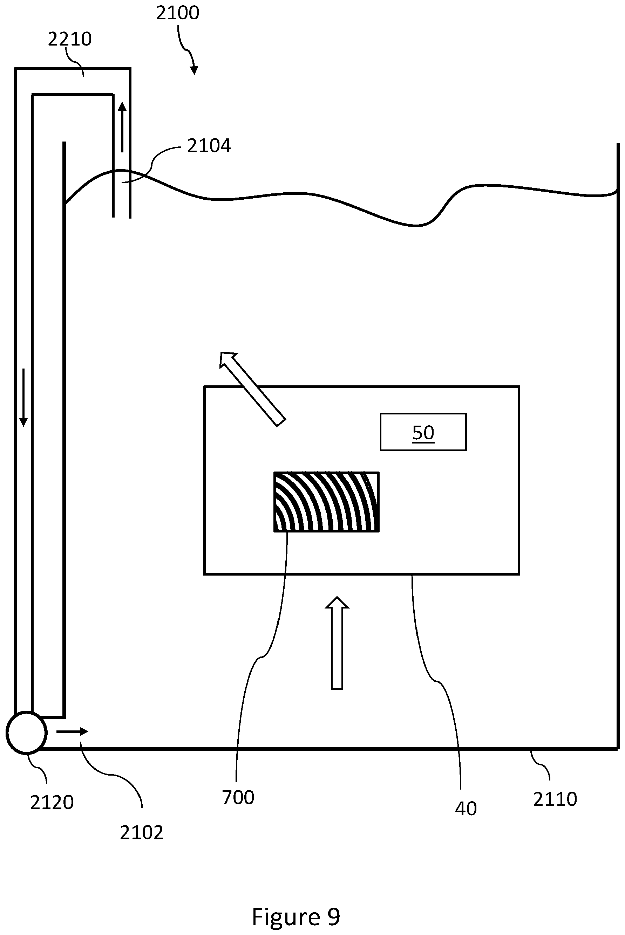

With reference to Figure 9, a support board 40 is disposed within the tank 2110, the support board 40 comprising a first heat generating component 50 (not visible), the heat sink 700 of Figure 7 disposed on the first heat generating component 50, and a second heat generating component 50. The second heat generating component 50 may be, for example, cooled via a channelized cooling liquid flowing in a conduit (not shown). As such, it may be desirable that the warm cooling fluid exiting the fin passages 124 of the heat sink 700 does not have thermal exchange with the second heat generating component 50. For example, a temperature of the cooling fluid exiting the fin passages 124 of the heat sink 700 may be above an operating temperature of the second heat generating component 50. The fins 120 of the heat sink 700 are thus positioned to orient a flow of the cooling fluid such that the latter is not directed towards the second heat generating component 50 upon exiting the fin passages 124. Dielectric cooling fluid that did not pass in the fin passages124 of the heat sink 700 may collect thermal energy of the second heat generating component 50.

More specifically, the dielectric heat transfer fluid entering the tank 2110 at the tank inlet 2102 is directed towards the support board 40 as the flow of dielectric cooling fluid is maintained between the tank inlet 2102 and the tank outlet 2104 by the pump 2120. The dielectric heat transfer fluid flows in the fin passages 124 of the fins 120 of the heat sink 700, thereby being directed substantially away from the second heat generating component 50.

Modifications and improvements to the above-described embodiments of the present technology may become apparent to those skilled in the art. The foregoing description is intended to be exemplary rather than limiting. The scope of the present technology is therefore intended to be limited solely by the scope of the appended claims.

## Claims

1. A heat sink (100, 600, 700) for collecting thermal energy from a heat generating component (50), the heat sink comprising:
a base (110) comprising:
a thermal transfer surface (130) configured to be placed in thermal contact with the heat-generating component (50);
an external surface (140) opposite from the thermal transfer surface (130); and an inlet side (130₁) of the base (110) extending between an edge of the thermal transfer surface (130) and an edge of the external surface (140);
and
a plurality of fins (120) extending from the external surface (140), the fins (120) defining a plurality of fin passages (124) therebetween, at least one fin of the plurality of fins (120) having non-straight longitudinal edges extending along the external surface (140) and defining at least in part at least one non-straight fin passage (124).

2. The heat sink (100, 600, 700) of claim 1, wherein fin sections of two adjacent fins (120) divergently extend from one another along the external surface (140).

3. The heat sink (100, 600, 700) of claim 1 or 2, wherein fin sections of two adjacent fins (120) convergently extend towards one another along the external surface (140).

4. The heat sink (100, 600, 700) of any one of claims 1 to 3, wherein at least two adjacent fins (120) define a curved fin passage (124) therebetween along the external surface (140).

5. The heat sink (100, 600, 700) of any one of claims 1 to 4, wherein the heat sink (100, 600, 700) is configured to be in thermal contact with an external fluid to transfer thermal energy from the heat generating component (50) to the external fluid.

6. The heat sink (100, 600, 700) of claim 5, wherein the external fluid is an immersive cooling liquid, the heat sink (100, 600, 700) being at least partially immersed in the immersive cooling liquid.

7. The heat sink (100, 600, 700) of claim 6, wherein the plurality of fins (120) is configured to allow the immersive cooling liquid to flow between the fins (120), the flow of the immersive cooling liquid being directed by longitudinal edges of the plurality of fins.

8. The heat sink (100, 600, 700) of claim 7, wherein the plurality of fins (120) is configured to direct the flow of the immersive cooling liquid in a plurality of directions.

9. The heat sink (100, 600, 700) of any one of claims 1 to 8, wherein the heat sink (100, 600, 700) is made of a material selected from copper, aluminum, an aluminum alloy and a combination thereof.

10. The heat sink (100, 600, 700) of any one of claims 1 to 9, wherein the at least one fin (120) defines a plurality of fin sections along the external surface (140) , each fin section extending at an angle with respect to a successive fin section.

11. An immersion cooling tank (2110) for cooling a heat-generating component (50), the immersion cooling tank (2110) comprising:
a heat sink (100, 600, 700) as defined in any one of claims 1 to 10 placed in thermal contact with the heat-generating component (50);
the immersion cooling tank (2110) being configured to circulate immersive cooling liquid such that the immersive cooling liquid flows between the fins (120), thereby transferring thermal energy from the heat sink (100, 600, 700) to the immersive cooling liquid.

12. A method for cooling a heat-generating component (50), the method comprising:
providing an immersion cooling tank (2110);
installing the heat sink (100, 600, 700) as defined in any one of claims 1 to 11 on the heat-generating component (50);
placing the heat-generating component (50) in the immersion cooling tank (2110); and
filling the immersion cooling tank (2110) with an immersive cooling liquid such that the immersive cooling liquid flows between the fins (120), thereby transferring thermal energy from the heat sink (100, 600, 700) to the immersive cooling liquid.

13. The method of claim 12, wherein the immersive cooling liquid is a dielectric liquid.

14. The method of claim 12 or 13, wherein the heat-generating component (50) is placed in the immersion cooling tank (2110) such that the plurality of fins (120) of the heat sink (100, 600, 700) extend generally horizontally.

15. The method of claim 12 or 13, further comprising:
disposing a tank liquid inlet (2102) in a vicinity of the inlet side (130₁) of the heat sink (100, 600, 700); and
orienting a flow of the immersive cooling liquid towards the inlet side (130i).

## Amended claims

### Amended claims in accordance with Rule 137(2) EPC.

1. A heat sink (100, 600, 700) for collecting thermal energy from a corresponding heat generating component (50), the heat sink (100, 600, 700) and the heat generating component (50) being at least partially disposed within an immersive cooling fluid, the heat sink comprising:
a base (110) comprising:
a thermal transfer surface (130) configured to be in direct thermal contact with the heat-generating component (50);
an external surface (140) opposite from the thermal transfer surface (130);
an inlet side (130₁) of the base (110) extending between an edge of the thermal transfer surface (130) and an edge of the external surface (140); and
a plurality of fins (120) extending from the external surface (140), the fins (120) defining a plurality of fin passages (124) to enable the flow of immersive cooling liquid therebetween, at least one fin of the plurality of fins (120) having non-straight longitudinal edges extending along the external surface (140) and defining at least in part at least one non-straight fin passage (124).

2. The heat sink (100, 600, 700) of claim 1, wherein fin sections of two adjacent fins (120) divergently extend from one another along the external surface (140).

3. The heat sink (100, 600, 700) of claim 1 or 2, wherein fin sections of two adjacent fins (120) convergently extend towards one another along the external surface (140).

4. The heat sink (100, 600, 700) of any one of claims 1 to 3, wherein at least two adjacent fins (120) define a curved fin passage (124) therebetween along the external surface (140).

5. The heat sink (100, 600, 700) of any one of claims 1 to 4, wherein the heat sink (100, 600, 700) is configured to transfer thermal energy from the heat generating component (50) to the immersive cooling fluid.

6. The heat sink (100, 600, 700) of claim 5, wherein the plurality of fins (120) is configured to allow the immersive cooling liquid to flow between the fins (120), the flow of the immersive cooling liquid being directed by longitudinal edges of the plurality of fins.

7. The heat sink (100, 600, 700) of claim 6, wherein the plurality of fins (120) is configured to direct the flow of the immersive cooling liquid in a plurality of directions.

8. The heat sink (100, 600, 700) of any one of claims 1 to 7, wherein the heat sink (100, 600, 700) is made of a material selected from copper, aluminum, an aluminum alloy and a combination thereof.

9. The heat sink (100, 600, 700) of any one of claims 1 to 8, wherein the at least one fin (120) defines a plurality of fin sections along the external surface (140), each fin section extending at an angle with respect to a successive fin section.

10. An immersion cooling tank (2110) for cooling a heat-generating component (50), the immersion cooling tank (2110) comprising:
a heat sink (100, 600, 700) as defined in any one of claims 1 to 9 placed in thermal contact with the heat-generating component (50);
the immersion cooling tank (2110) being configured to circulate immersive cooling liquid such that the immersive cooling liquid flows between the fins (120), thereby transferring thermal energy from the heat sink (100, 600, 700) to the immersive cooling liquid.

11. A method for cooling a heat-generating component (50), the method comprising:
providing an immersion cooling tank (2110);
installing the heat sink (100, 600, 700) as defined in any one of claims 1 to 10 on the heat-generating component (50);
placing the heat-generating component (50) in the immersion cooling tank (2110); and
filling the immersion cooling tank (2110) with an immersive cooling liquid such that the immersive cooling liquid flows between the fins (120), thereby transferring thermal energy from the heat sink (100, 600, 700) to the immersive cooling liquid.

12. The method of claim 11, wherein the immersive cooling liquid is a dielectric liquid.

13. The method of claim 11 or 12, wherein the heat-generating component (50) is placed in the immersion cooling tank (2110) such that the plurality of fins (120) of the heat sink (100, 600, 700) extend generally horizontally.

14. The method of claim 12 or 13, further comprising:
disposing a tank liquid inlet (2102) in a vicinity of the inlet side (130₁) of the heat sink (100, 600, 700); and
orienting a flow of the immersive cooling liquid towards the inlet side (130₁).
